# EUROPEAN PATENT APPLICATION

(11) **EP 4 343 997 A1**
(43) Date of publication of application: **27.03.2024**
(21) Application number: 23157340.3
(22) Date of filing: 17.02.2023
(51) Int. Cl.: H02H 3/02, H02H 3/20, H02H 5/04, H02H 9/04, H02H 3/00

(54) **ELECTRONIC DEVICE AND METHOD FOR PROTECTING EQUIPMENT FROM VOLTAGE SURGE DAMAGE**

(30) Priority: 20.09.2022 US 202263408111 P; 02.02.2023 US 202318163300
(71) Applicant: Bamboo Dynamics Corporation., Ltd., Jubei, Hsinchu 302058 (TW)
(72) Inventor: CHAN, Yuan Chen, 302058 Jubei, Hsinchu (TW); CHUANG, Chi-Ming, 300060 Hsinchu City (TW)
(74) Representative: Becker, Eberhard

(57) **Abstract**

An electronic device (100) and a method for protecting an equipment from voltage surge damage are provided. The method includes: electrically connecting an input terminal of a one-way pass circuit (100) to a first equipment (10) and electrically connecting an output terminal of the one-way pass circuit to a second equipment (20); electrically connecting an over-voltage check circuit (120) to the output terminal and a regenerative resistor circuit (130), wherein the regenerative resistor circuit includes a resistor (132); detecting, by the over-voltage check circuit, a voltage of the output terminal; and electrically, by the over-voltage check circuit, connecting the output terminal to the resistor in response to the voltage being greater than a voltage threshold.

Fig. 1

## Description

### BACKGROUND

### Technical Field

The disclosure is directed to an electronic device and a method for protecting an equipment from voltage surge damage.

### Description of Related Art

Logistics automation is a precise process where different motors in a conveyor system may stop or start at different times. When a motor stops suddenly, the voltage on the power line may surge and cause damage to the power line or to the motor controller. Dedicated power supplies for motors may have built-in protection to prevent voltage surges from returning to the equipment, while the voltage surge to the motor controller can be avoided by configuring more gentle stops. However, there are cases when these adjustments are not practical, such as when existing power supplies without built-in protection are used or when urgent motor braking is necessary. Therefore, a separate protector device against power surges is needed.

### SUMMARY

The disclosure is directed to an electronic device and a method for protecting an equipment from voltage surge damage. The disclosure may protect an equipment from voltage surge according to a voltage detection result.

The disclosure is directed to an electronic device for protecting an equipment from voltage surge damage, including a one-way pass circuit, a regenerative resistor circuit, and an over-voltage check circuit. The one-way pass circuit includes an input terminal electrically connected to a first equipment and an output terminal electrically connected to a second equipment. The regenerative resistor circuit includes a resistor. The over-voltage check circuit is electrically connected to the output terminal and the regenerative resistor circuit, wherein the over-voltage check circuit detects a voltage of the output terminal, and electrically connects the output terminal to the resistor in response to the voltage being greater than a voltage threshold.

In one embodiment of the disclosure, the regenerative resistor circuit further including a switch connected to the over-voltage check circuit, the output terminal, and the resistor, wherein the over-voltage check circuit electrically connects the output terminal to the resistor by turning on the switch.

In one embodiment of the disclosure, the switch including a metal-oxide-semiconductor field-effect transistor.

In one embodiment of the disclosure, the electronic device, further including a thermal protector circuit, electrically connected to the over-voltage check circuit, wherein the thermal protector circuit detects a temperature of the resistor, wherein the over-voltage check circuit electrically connects the output terminal to the resistor in response to the temperature being less than a temperature threshold.

In one embodiment of the disclosure, the electronic device further including a clamp voltage select circuit electrically connected to the over-voltage check circuit, wherein the over-voltage check circuit configures the voltage threshold according to a command from the clamp voltage select circuit.

In one embodiment of the disclosure, the first equipment including a power supply and the second equipment including a motor.

The disclosure is directed to a method for protecting an equipment from voltage surge damage, including: electrically connecting an input terminal of a one-way pass circuit to a first equipment and electrically connecting an output terminal of the one-way pass circuit to a second equipment; electrically connecting an over-voltage check circuit to the output terminal and a regenerative resistor circuit, wherein the regenerative resistor circuit includes a resistor; detecting, by the over-voltage check circuit, a voltage of the output terminal; and electrically, by the over-voltage check circuit, connecting the output terminal to the resistor in response to the voltage being greater than a voltage threshold.

According to the above description, the present disclosure may protect an equipment from the voltage surges by simply configuring the electronic device between the power source and the protected equipment.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 illustrates a schematic diagram of an electronic device for protecting an equipment from voltage surge damage according to an embodiment of the disclosure.
FIG. 2 illustrates a flowchart of a method for protecting an equipment from voltage surge damage according to an embodiment of the disclosure.

### DESCRIPTION OF THE EMBODIMENTS

In order to make the disclosure more comprehensible, several embodiments are described below as examples of implementation of the disclosure. Moreover, elements/components/steps with the same reference numerals are used to represent identical or similar parts in the figures and embodiments where appropriate.

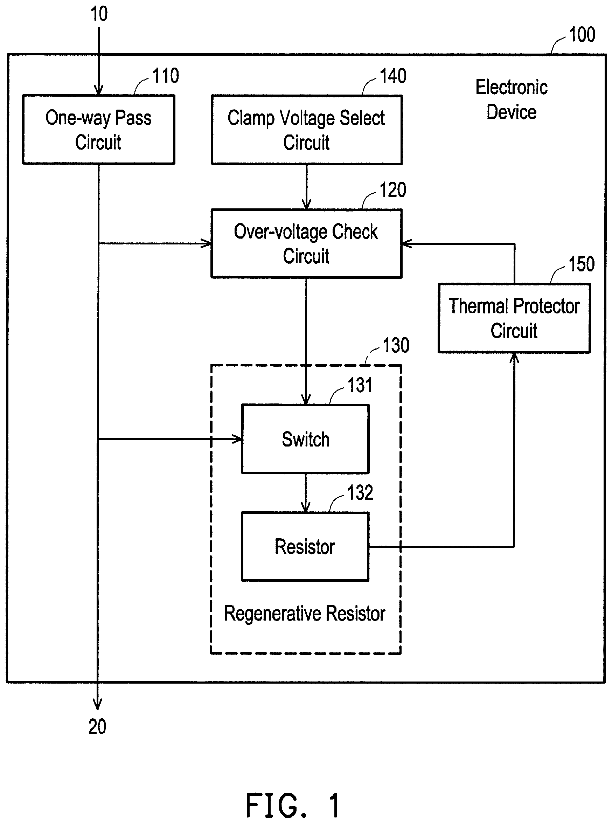

FIG. 1 illustrates a schematic diagram of an electronic device 100 for protecting an equipment from voltage surge damage according to an embodiment of the disclosure. The electronic device 100 may be configured between the equipment 10 and the equipment 20, wherein the equipment 10 may include a power supply and the equipment 20 may include an electrical load such as a motor control card. The electronic device 100 may protect the equipment 10 from voltage surge damage caused by the stopping of the equipment 20.

The electronic device 100 may include a one-way pass circuit 110, an over-voltage check circuit 120, a regenerative resistor circuit 130, a clamp voltage select circuit 140, and a thermal protector circuit 150. The input terminal of the one-way pass circuit 110 may electrically connect to the equipment 10 and the output terminal of the one-way pass circuit 110 may electrically connect to the equipment 20. The one-way pass circuit 110 may limit the direction of signals (e.g., power current or voltage) such that the signals can only be transmitted from the equipment 10 to the equipment 20. The signals from the equipment 20 cannot be transmitted to the equipment 10 through the one-way pass circuit 110. When a voltage surge occurs in the powered equipment 20, the power surge cannot pass through the one-way pass circuit 110. In one embodiment, the one-way pass circuit 110 may be implemented by an ORing diode.

The regenerative resistor circuit 130 may include a switch 131 and a resistor 132 electrically connected to the switch 131. The resistor 132 may be connected to the ground. The switch 131 may electrically connect to the output terminal of the one-way pass circuit 110 and the over-voltage check circuit 120. The switch 131 may be controlled by the over-voltage check circuit 120 to electrically connect the output terminal of the one-way pass circuit 110 to the resistor 132 or disconnect the output terminal of the one-way pass circuit 110 from the resistor 132.

In one embodiment, the switch 131 may include a metal-oxide-semiconductor field-effect transistor (MOSFET). The source of the MOSFET may connect to one of the output terminal of the one-way pass circuit 110 and the resistor 132, and the drain of the MOSFET may connect to the other one of the output terminal of the one-way pass circuit 110 and the resistor 132. For example, the source of the MOSFET may connect to the output terminal of the one-way pass circuit 110 if the drain of the MOSFET is connected to the resistor 132. The gate of the MOSFET may connect the over-voltage check circuit 120. The over-voltage check circuit 120 may electrically connect the output terminal of the one-way pass circuit 110 to the resistor 132 by turning on the MOSFET, and may disconnect the output terminal of the one-way pass circuit 110 from the resistor 132 by turning off the MOSFET.

The over-voltage check circuit 120 may detect a voltage of the output terminal of the one-way pass circuit 110. If the voltage is greater than a voltage threshold, the over-voltage check circuit 120 may turn on the switch 131 so as to electrically connect the output terminal of the one-way pass circuit 110 to the resistor 132. Accordingly, the over-voltage power may be consumed by the resistor 132. If the voltage is less than or equal to the voltage threshold, the over-voltage check circuit 120 may turn off the switch 131 so as to disconnect the output terminal of the one-way pass circuit 110 from the resistor 132.

The clamp voltage select circuit 140 may electrically connect to the over-voltage check circuit. In one embodiment, the clamp voltage select circuit 140 may include a DIP switch. The clamp voltage select circuit 140 may be operated by a user and transmit a command to the over-voltage check circuit 120 accordingly. The over-voltage check circuit 120 may configure the voltage threshold according to the command from the clamp voltage select circuit 140.

The thermal protector circuit 150 may electrically connect to the over-voltage check circuit 120. The thermal protector circuit 150 may detect a temperature of the resistor 132. If the temperature of the resistor 132 is less than a temperature threshold, the thermal protector circuit 150 may allow the over-voltage check circuit 120 to control the switch 131 by transmitting a command to the over-voltage check circuit 120, so as to electrically connect the output terminal of the one-way pass circuit 110 to the resistor 132 by the over-voltage check circuit 120 when the voltage of the output terminal exceeds the voltage threshold. That is, the output terminal of the one-way pass circuit 110 may be electrically connected to the resistor 132 if the resistor 132 does not overheat. On the other hand, if the temperature of the resistor 132 is greater than or equal to the temperature threshold, the thermal protector circuit 150 may command the over-voltage check circuit 120 to turn off the switch 131, so as to disconnect the output terminal of the one-way pass circuit 110 from the resistor 132. Accordingly, the resistor 132 will not overheat.

The over-voltage check circuit 120 may turn on or turn off the switch 131 according to both of the voltage of the output terminal of the one-way pass circuit 110 and the temperature of the resistor 132. In one embodiment, protecting the equipment 10 from overvoltage may prioritize over protecting the resistor 132 from overheating. Accordingly, the over-voltage check circuit 120 may determine to turn off the switch 131 in response to the temperature of the resistor 132 being greater than the temperature threshold only if the voltage of the output terminal of the one-way pass circuit 110 is less than or equal to the voltage threshold. In another embodiment, protecting the resistor 132 from overheating may prioritize over protecting the equipment 10 from overvoltage. Accordingly, the over-voltage check circuit 120 may determine to turn on the switch 131 in response to the voltage of the output terminal of the one-way pass circuit 110 being greater than the voltage threshold only if the temperature of the resistor 132 is less than the temperature threshold.

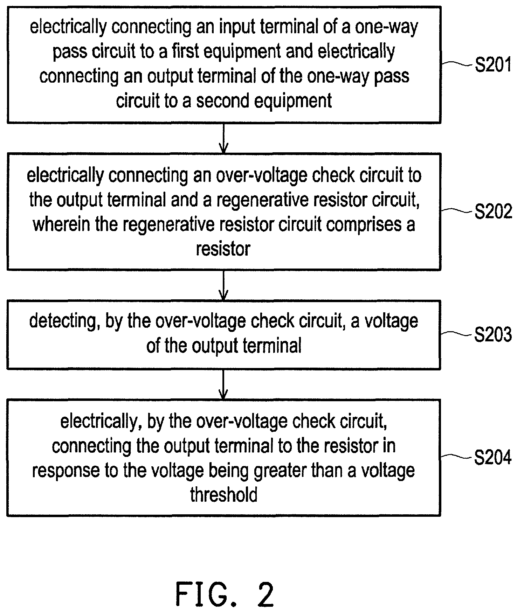

FIG. 2 illustrates a flowchart of a method for protecting an equipment from voltage surge damage according to an embodiment of the disclosure, wherein the method may be implemented by the electronic device 100 as shown in FIG. 1. In step S201, electrically connecting an input terminal of a one-way pass circuit to a first equipment and electrically connecting an output terminal of the one-way pass circuit to a second equipment. In step S202, electrically connecting an over-voltage check circuit to the output terminal and a regenerative resistor circuit, wherein the regenerative resistor circuit comprises a resistor. In step S203, detecting, by the over-voltage check circuit, a voltage of the output terminal. In step S204, electrically, by the over-voltage check circuit, connecting the output terminal to the resistor in response to the voltage being greater than a voltage threshold.

In summary, the electronic device of the present disclosure may configure a one-way pass circuit between the protected equipment and the power source. The electronic device may detect the voltage of the output terminal of the one-way pass circuit and may connect the output terminal to the resistor if the detected voltage is greater than a voltage threshold. Accordingly, the voltage surge may be directed to the ground rather than directed to the equipment. The resistor directing the power surge to the ground may be protected from burning out by a thermal protector circuit.

## Claims

1. An electronic device (100) for protecting an equipment from voltage surge damage, comprising:
a one-way pass circuit (110), comprising an input terminal electrically connected to a first equipment (10) and an output terminal electrically connected to a second equipment (20);
a regenerative resistor circuit (130), comprising a resistor (132); and
an over-voltage check circuit (120), electrically connected to the output terminal and the regenerative resistor circuit (130), wherein the over-voltage check circuit (120) detects a voltage of the output terminal, and electrically connects the output terminal to the resistor (132) in response to the voltage being greater than a voltage threshold.

2. The electronic device (100) according to claim 1, wherein the regenerative resistor circuit (130) further comprising:
a switch (131), connected to the over-voltage check circuit (120), the output terminal, and the resistor (132), wherein the over-voltage check circuit (120) electrically connects the output terminal to the resistor (132) by turning on the switch (131).

3. The electronic device (100) according to claim 2, wherein the switch (131) comprising a metal-oxide-semiconductor field-effect transistor.

4. The electronic device (100) according to claim 1, further comprising:
a thermal protector circuit (150), electrically connected to the over-voltage check circuit (120), wherein the thermal protector circuit (150) detects a temperature of the resistor (132), wherein
the over-voltage check circuit (120) electrically connects the output terminal to the resistor (132) in response to the temperature being less than a temperature threshold.

5. The electronic device (100) according to claim 1, further comprising:
a clamp voltage select circuit (140), electrically connected to the over-voltage check circuit (120), wherein the over-voltage check circuit (120) configures the voltage threshold according to a command from the clamp voltage select circuit (140).

6. The electronic device (100) according to claim 1, wherein the first equipment (10) comprising a power supply and the second equipment (20) comprising a motor.

7. A method for protecting an equipment from voltage surge damage, comprising:
electrically connecting an input terminal of a one-way pass circuit to a first equipment and electrically connecting an output terminal of the one-way pass circuit to a second equipment (S201);
electrically connecting an over-voltage check circuit to the output terminal and a regenerative resistor circuit, wherein the regenerative resistor circuit comprises a resistor (S202);
detecting, by the over-voltage check circuit, a voltage of the output terminal (S203); and
electrically, by the over-voltage check circuit, connecting the output terminal to the resistor in response to the voltage being greater than a voltage threshold (S204).
